# EUROPEAN PATENT SPECIFICATION

(11) **EP 0 467 190 B1**
(45) Date of publication and mention of the grant of the patent: **19.03.1997**
(21) Application number: 91111362.9
(22) Date of filing: 08.07.1991
(51) Int. Cl.: H01L 21/768, H01L 21/334, H01L 21/285, H01L 21/3205

(54) **Process for depositing highly doped polysilicon layer on stepped surface of semiconductor wafer resulting in enhanced step coverage**
Verfahren zur Abscheidung einer hochdotierten Polysiliciumschicht auf eine stufenförmige Halbleiterwaferfläche, welches verbesserte Stufenbeschichtung liefert
Procédé de dépôt d'une couche de polysilicium fortement dopée sur une surface échelonnée d'une plaquette semi-conductrice conduisant un revêtement de degrés amélioré

(30) Priority: 16.07.1990 US 572280
(43) Date of publication of application: 22.01.1992
(73) Proprietor: APPLIED MATERIALS, INC., Santa Clara, California 95052 (US)
(72) Inventor: Beinglass, Israel, Sunnyvale, California 94087 (US)
(74) Representative: Kahler, Kurt, Dipl.-Ing.

(56) References cited:
- US-A- 4 626 317
- US-A- 4 650 696
- US-A- 4 977 104
- PATENT ABSTRACTS OF JAPAN vol. 014, no. 429 (E-0978), 14 September 1990; & JP-A-2165663
- IBM TECHNICAL DISCLOSURE BULLETIN vol. 33, no. 5, October 1990, pages 473,474, Armonk, NY, US; "Multi-shell trench capacitor cell for quarter giga bit dram and beyond"

## Description

### 1. Field of the Invention

This invention relates to a process for depositing a doped layer of polysilicon over a stepped surface of a semiconductor wafer in accordance with the precharacterizing portion of claim 1. More particularly, this invention relates to a process wherein polysilicon can be deposited over a stepped surface of a semiconductor wafer in a manner which will provide a doped polysilicon layer having the deposition profile of an undoped polysilicon.

### 2. Description of the Related Art

In the construction of integrated circuit structures on semiconductor wafers, trenches may be formed in the wafer, or raised lines (steps) may be formed over the surface of the wafer, either of which, for example, can result in an uneven or stepped surface on the wafer with low areas corresponding to the location of such trenches or regions between raised lines. It is sometimes desirable to form a doped layer of polysilicon over such a stepped surface, for example, to form a conductive line over or between oxide-covered steps, or to fill an oxide-coated trench with a conductor to form a capacitor.

It is usually desirable to completely fill up such low areas between raised portions on the wafer, when depositing a layer such as polysilicon thereon. Unfortunately, this is difficult to accomplish with a doped polysilicon since doped polysilicon tends to deposit faster on horizontal surfaces than on vertical surfaces. The result has been the formation of a thick layer of doped polysilicon over the raised portions of the integrated circuit structure, e.g., on top of the steps or on the horizontal wafer surfaces adjoining a trench, while the low areas remain partially unfilled.

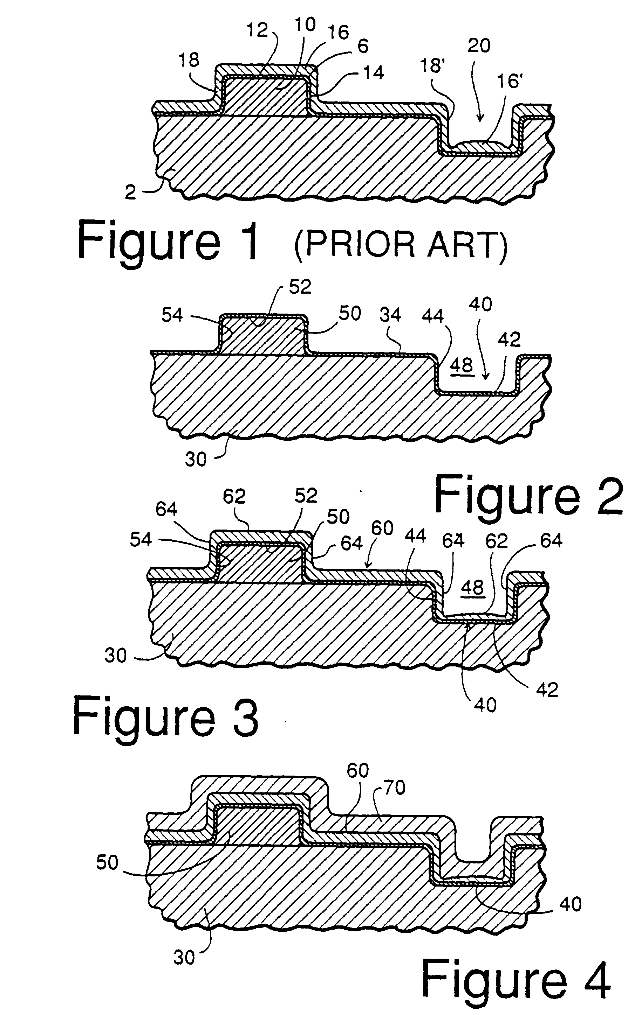

This is shown in Figure 1, which illustrates such a prior art deposition of doped polysilicon over a stepped surface of a semiconductor wafer. As shown therein, the doped polysilicon 16 horizontally deposited on the top surface 12 of oxide layer 6 formed over step 10 on wafer 2 is thicker than the doped polysilicon 18 deposited vertically on the sidewall surfaces 14 of oxide layer 6 on step 10. Polysilicon 16' formed over the oxide-coated horizontal bottom surface of trench 20 in wafer 2 is similarly deposited thicker than the vertically deposited polysilicon 18' on the sidewalls of trench 20 in the prior art structure of Figure 1.

The result of such uneven deposition of doped polysilicon is that if the low region is to be completely filled, the entire structure must either be deposited to a greater thickness, with high portions of the resulting polysilicon layer then removed in a separate step.

It would, therefore, be desirable to provide a process wherein a layer of doped polysilicon could be deposited which would completely fill low segments between raised portions on a semiconductor wafer, i. e., would have the deposition characteristics and resulting profile of an undoped polysilicon layer.

US-PS 4,977,104 discloses a process according to the precharacterizing portion of claim 1 but operates at a very low deposition rate which makes the process unpractical and uneconomic.

It is, therefore, an object of this invention to provide a process for depositing doped polysilicon over a stepped surface in a semiconductor wafer which will fill low segments between raised portions on the wafer which process allows a high deposition rate.

This object is achieved by a process for forming a doped polysilicon layer over a stepped surface on a semiconductor wafer comprising the features of claim 1.

Improvements of the process of the invention are characterized in the dependent claims.

Figure 1 is a fragmentary vertical cross-sectional view of a prior art deposition of a doped polysilicon layer over a stepped semiconductor wafer surface.

Figure 2 is a fragmentary cross-sectional view of a semiconductor wafer shown with a raised step formed on its surface and a trench extending down into the wafer.

Figures 3-7 are sequential fragmentary vertical cross-sectional views showing the alternate deposition of doped and undoped polysilicon layers on the wafer of Figure 2 using the deposition process of the invention.

Figure 8 is a graph plotting the concentration of dopant versus depth of the layer of polysilicon deposited on the stepped wafer by the process of the invention prior to annealing, showing the nonuniform distribution of the dopant in the deposited layer.

Figure 9 is a graph plotting the concentration of dopant versus depth of the same layer of polysilicon deposited on the stepped wafer by the process of the invention as shown in the graph of Figure 5, but after annealing, showing the uniform distribution of dopant throughout the deposited layer.

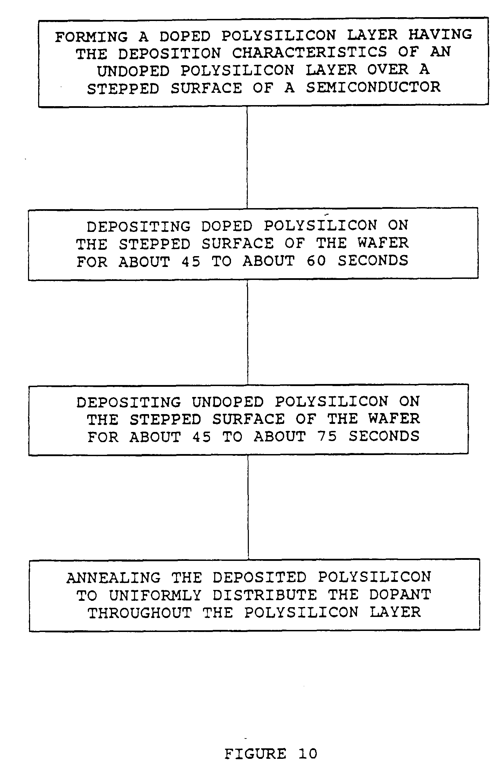

Figure 10 is a flowsheet illustrating the process of the invention.

### Detailed Description of the Invention

The process of the invention provides for the formation of a doped layer of polysilicon over a stepped surface of a semiconductor wafer in a manner which will result in the substantial filling of the low segments or areas adjacent raised portions of the wafer, by using sequential deposition steps of depositing doped and undoped polysilicon followed by an annealing step to uniformly distribute the dopant throughout the deposited polysilicon layer.

By use of the term "doped polysilicon layer" is meant a polysilicon layer having a concentration of dopant therein (which may comprise either N type or P type dopant, e.g., phosphorus, boron, arsenic) ranging from about 1 x 10²⁰ to about 2 x 10²¹ atoms/cm³. While the process may be used in the formation of either a P type or N type doped polysilicon layer over a stepped semiconductor wafer surface, by way of illustration, and not of limitation, the process will described in connection with the formation of a phosphorus-doped polysilicon layer.

In the use of the expression "low segments adjacent raised portions of the wafer" herein, the term "low segments" is intended to refer both to the volume within a trench, as well as to areas on the wafer between raised steps. The term "raised portions" is intended to refer both to those portions of the wafer adjacent such a trench, as well as to raised steps on the wafer surface.

Now referring to Figure 2, a semiconductor wafer 30 is shown having formed therein a trench 40, having a bottom wall surface 42 and sidewall surfaces 44, leaving an unfilled volume therein generally indicated at 48. Wafer 30 also has a raised step 50 formed thereon, having a top surface 52 and sidewall surfaces 54. As shown, an oxide coating 34 may be formed over the entire surface of wafer 30, including surfaces 42, 44, 52, and 54, respectively, in trench 40 and on step 50.

A first layer of doped polysilicon 60 is now formed over wafer 30 in a vacuum deposition chamber maintained at a pressure of from about 25 to about 200 - Torr and a wafer temperature ranging from about 600°C to about 700°C.

The deposition is carried out by flowing a source of silicon, a source of dopant, and an optional carrier gas into the chamber to form first doped polysilicon layer 60, as shown in Figure 3. This may be accomplished, for example, by flowing a source of silicon, such as silane (SiH₄), into the deposition chamber at a flow equivalent to from about 100 to about 1000 standard cubic centimeters/minute (sccm), typically about 500 sccm, through a 3 liter deposition chamber and a gaseous dopant mixture of 1 volume % PH₃ and 99 volume % H₂ flowing into the chamber at a flow rate equivalent to from about 200 to about 2000 sccm, typically about 1000 sccm, through a 3 liter deposition chamber.

Other materials can be utilized as sources of silicon in the practice of the method of the invention such as, for example, Si₂H₆.

Other dopant gases which may be used instead of PH₃, include, for example, BCl₃, B₂H₃, and AsH₃.

Optional carrier gases which may also be flowed into the deposition chamber during the polysilicon deposition process of the invention include Argon, Helium, and Nitrogen, typically at a flow rate, for a 3 liter deposition chamber, of from about 5000 to about 30 sccm.

This deposition step may be carried out for a time period of from about 20 seconds to about 2 minutes, typically about 45 seconds to about 1 minute, resulting in the structure shown in Figure 3, with doped polysilicon layer 60 deposited thereon to an average thickness of from about 400 to about 800 Angstroms (10 Angstroms = 1 nm) having thick portions 62 formed over horizontal surfaces, such as the horizontal top surface 52 of step 50 and on the horizontal bottom surface 42 of trench 40 and thinner portions 64 formed over vertical surfaces, such as sidewall surfaces 44 and 54.

At this point in the process, the flow of the dopant source is shut off, while the source of silicon continues to flow into the deposition chamber resulting in the deposition of an undoped polysilicon layer 70 of substantially uniform thickness over doped polysilicon layer 60, as shown in Figure 4. This deposition of undoped polysilicon may be continued for a time period of from about 20 seconds to about 1.5 minutes, preferably from about 45 to about 75 seconds, and typically about 1 minute, resulting in the deposition of an undoped polysilicon layer of from about 400 to about 800 Angstroms thick, after which the flow of dopant is against started resulting in the deposition of further doped polysilicon.

This cyclical deposition of doped and undoped polysilicon may be repeated additional times until the desired amount or thickness of polysilicon has been deposited on the stepped wafer surface, i.e., usually until the low areas or segments on the wafer between raised portions has been substantially filled with polysilicon.

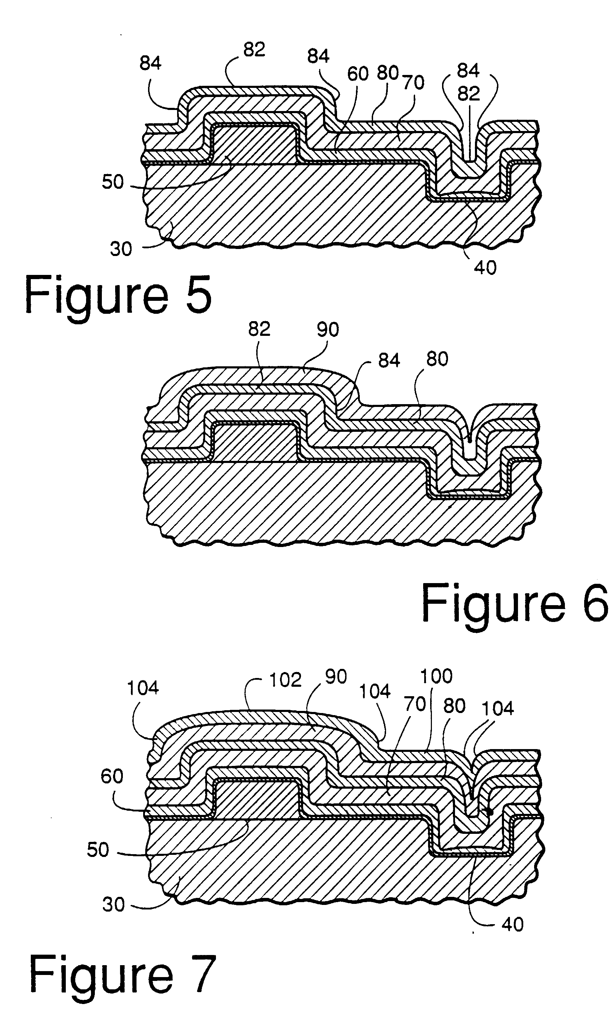

Figures 5-7 show step by step the deposition of a second doped polysilicon layer 80 with thick horizontal portions 82 and thinner vertical portions 84 (Figure 5); the deposition of a second undoped polysilicon layer 90 of uniform thickness (Figure 6); and the deposition of a third undoped polysilicon layer 100 having thicker horizontal portions 102 and thinner vertical portions 104 (Figure 7), although it will be noted that by this time the low regions or areas are filling up and rounding off so that the distinctions between vertical and horizontal surfaces are not as pronounced.

The deposited polysilicon is then annealed at a temperature within a range of from about 850° C to about 1000°C for a period of from 10 minutes to about 1 hour. Alternatively, the anneal may be carried out as a rapid thermal anneal wherein the temperature is rapidly raised to the desired annealing temperature stated above at a rate of from about 50° C/second up to about 100°C/second, and then maintained at this temperature for from 10 to 60 seconds. This annealing step uniformly distributes the dopant throughout the deposited polysilicon, resulting in the formation of a single homogeneously doped polysilicon layer.

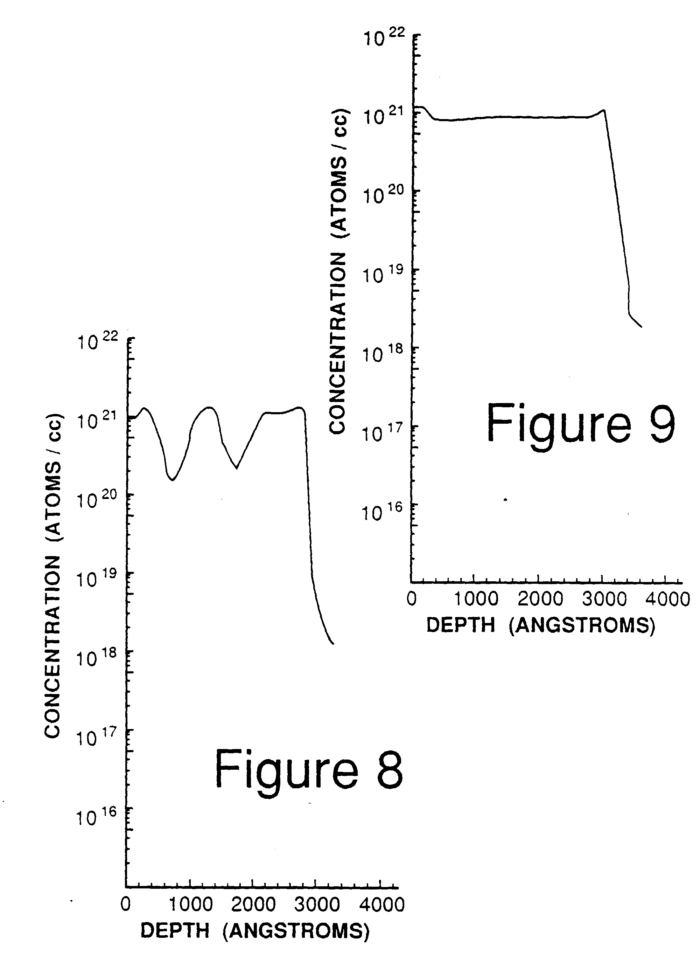

As shown in the SIMS graph of Figure 8, which represents the dopant concentration levels in the polysilicon layer (layers) on the wafer versus depth, after completion of the polysilicon deposition, but prior to the annealing step, the dopant which is cyclically deposited with the polysilicon, initially is present only in those layers of polysilicon which were deposited while the dopant gas mixture was also flowing into the deposition chamber, i.e., polysilicon layers 60, 80, and 100, with the polysilicon layers deposited intermediate to such doped layers, i.e., layers 70 and 90, containing little if any dopant.

However, as shown in the SIMS graph of Figure 9, which is performed on the wafer after the multiple layers of doped and undoped polysilicon have been annealed, the dopant is uniformly distributed throughout the entire layer of deposited and annealed polysilicon which now represent a single uniform and homogeneously doped polysilicon layer.

Thus, the process enables one to deposit a layer of polysilicon which will have a dopant content equal to that of a deposited doped polysilicon layer, yet have the deposition characteristics and profile of an undoped deposited polysilicon layer, i.e., will have a substantially uniform thickness of deposition on both the horizontal and vertical surfaces of the stepped wafer.

## Claims

1. A process for forming a doped polysilicon layer over a stepped surface on a semiconductor wafer (30) which comprises:
a) depositing doped polysilicon (60) on said stepped surface (40, 50) from a source of silicon and a dopant gas at a temperature within the range of about 600 to 700°C and a pressure in the range of about 3325 to 26660 Pa (25 to 200 Torr);
b) depositing undoped polysilicon (70) over the doped polysilicon layer (60) from a source of silicon at a temperature within the range of about 600 to 700°C and a pressure in the range of about 3325 to 26660 Pa (25 to 200 Torr); and
c) annealing said deposited polysilicon layers at a temperature within a range of 850°C to 1000°C to uniformly distribute the dopant throughout the deposited polysilicon layers.

2. The process of claim 1,
wherein the steps a) and b) are each repeated at least one additional time to increase the thickness of the deposited layer of polysilicon.

3. The process of claim 1 or 2,
wherein step a) is carried out for a time period of from about 20 seconds to about 2 minutes, preferably from about 45 seconds to about 1 minute.

4. The process of any of claims 1 to 3,
wherein step b) is carried out for a time period of from about 20 seconds to about 1.5 minutes, preferably from about 45 seconds to about 1 minute.

5. The process of any of claims 1 to 4,
wherein said polysilicon deposited on said wafer is annealed at a temperature of from about 850°C to about 1000°C for a period of from about 10 minutes to about 60 minutes.

6. The process of any of claims 1 to 4,
wherein said polysilicon deposited on said wafer is rapidly annealed by raising the temperature of the coated wafer to an annealing temperature of from about 850°C to about 1000°C at a rate of from about 50°C/second to about 100°C/second and then maintaining the wafer at said annealing temperature for a period of from about 10 seconds to about 60 seconds.

7. The process of any of claims 2 to 6,
wherein said source of silicon is flowed into said chamber at a rate equivalent to from about 100 to about 1000 sccm into a 3 liter chamber, said source of silicon preferably being a silane gas, more preferably SiH₄ and/or Si₂H₆.

8. The process of claims 2 to 7,
wherein said dopant is phosphorus, preferably PH₃, specifically as a mixture of about 1 volume % PH₃ and about 99 volume % H₂, or B₂H₃, BCl₃ or AsH₃.

## Patentansprüche

1. Ein Verfahren zum Ausbilden einer dotierten Polysiliciumschicht auf einer stufenförmigen Oberfläche auf einem Halbleiterwafer (30), das aufweist:
a) Abscheiden eines dotierten Polysiliciums (60) auf der stufenförmigen Oberfläche (40, 50) aus einem Ausgangsstoff für Silicium und einem Dotierstoffgas bei einer Temperatur im Bereich von ungefähr 600 bis 700°C und einem Druck im Bereich von ungefähr 3325 bis 26660 Pa (25 bis 200 Torr);
b) Abscheiden von undotiertem Polysilicium (70) auf der dotierten Polysiliciumschicht (60) aus einem Ausgangsstoff für Silicium bei einer Temperatur im Bereich von ungefähr 600 bis 700°C und einem Druck im Bereich von ungefähr 3325 bis 26660 Pa (25 bis 200 Torr); und
c) Tempern der abgeschiedenen Polysiliciumschichten bei einer Temperatur im Bereich von 850°C bis 1000°C, um den Dotierstoff gleichmäßig durch die gesamten, abgeschiedenen Polysiliciumschichten hindurch zu verteilen.

2. Das Verfahren nach Anspruch 1,
bei dem die Schritte a) und b) jeweils mindestens ein zusätzliches Mal wiederholt werden, um die Dicke der abgeschiedenen Polysiliciumschicht zu erhöhen.

3. Das Verfahren nach Anspruch 1 oder 2,
bei dem der Schritt a) für eine Zeitdauer von ungefähr 20 Sekunden bis ungefähr 2 Minuten, vorzugsweise von ungefähr 45 Sekunden bis ungefähr 1 Minute, ausgeführt wird.

4. Das Verfahren nach irgendeinem der Ansprüche 1 bis 3,
bei dem der Schritt b) für eine Zeitdauer von ungefähr 20 Sekunden bis ungefähr 1,5 Minuten, vorzugsweise von ungefähr 45 Sekunden bis ungefähr 1 Minute, ausgeführt wird.

5. Das Verfahren nach irgendeinem der Ansprüche 1 bis 4,
bei dem das auf dem Wafer abgeschiedene Polysilicium bei einer Temperatur von ungefähr 850°C bis ungefähr 1000°C für eine Dauer von ungefähr 10 Minuten bis ungefähr 60 Minuten getempert wird.

6. Das Verfahren nach irgendeinem der Ansprüche 1 bis 4,
bei dem das auf dem Wafer abgeschiedene Polysilicium schnell getempert wird, indem die Temperatur des beschichteten Wafers mit einer Rate von ungefähr 50°C/Sekunde bis ungefähr 100°C/Sekunde auf eine Temperungstemperatur von ungefähr 850°C bis ungefähr 1000°C angehoben wird und der Wafer dann bei der Temperungstemperatur für eine Dauer von ungefähr 10 Sekunden bis ungefähr 60 Sekunden gehalten wird.

7. Das Verfahren nach irgendeinem der Ansprüche 2 bis 6,
bei dem der Ausgangsstoff für Silicium in die Kammer mit einem Ratenäquivalent von ungefähr 100 bis ungefähr 1000 sccm in eine 3-Liter-Kammer eingeleitet wird, wobei der Ausgangsstoff für Silicium vorzugsweise Silangas ist, am vorteilhaftesten SiH₄ und/oder Si₂H₆.

8. Das Verfahren nach den Ansprüchen 2 bis 7,
bei dem der Dotierstoff Phosphor ist, vorzugsweise PH₃, besonders als eine Mischung von ungefähr 1 Volumen% PH₃ und ungefähr 99 Volumen% H₂, oder B₂H₃, BCl₃ oder AsH₃.

## Revendications

1. Procédé de formation d'une couche de polysilicium dopé sur une surface étagée d'une plaquette semi-conductrice (30) qui comprend:
a) le dépôt de polysilicium dopé (60) sur ladite surface étagée (40, 50) à partir d'une source de silicium et d'un gaz dopant à une température comprise dans la plage de 600 à 700°C environ et à une pression comprise dans l'intervalle de 3325 à 26660 Pa environ (25 à 200 Torr);
b) le dépôt de polysilicium non dopé (70) sur la couche de polysilicium dopé (60) à partir d'une source de silicium à une température comprise dans la plage de 600 à 700°C environ et à une pression comprise dans l'intervalle de 3325 et 26660 Pa environ(25 à 200 Torr); et
c) le recuit desdites couches de polysilicium déposées à une température comprise dans la plage de 850 à 1000°C en vue de répartir uniformément le dopant à travers les couches de polysilicium déposées.

2. Procédé selon la revendication 1,
dans lequel les étapes a) et b) sont répétées chacune au moins une fois en vue d'accroître l'épaisseur de la couche de polysilicium déposée.

3. Procédé selon la revendication 1 ou 2, dans lequel la durée d'exécution de l'étape a) est d'environ 20 secondes à environ 2 minutes, de préférence d'environ 45 secondes à environ 1 minute.

4. Procédé selon l'une quelconque des revendications 1 à 3, dans lequel la durée d'exécution de l'étape b) est d'environ 20 secondes à environ 1,5 minute, de préférence d'environ 45 secondes à environ 1 minute.

5. Procédé selon l'une quelconque des revendications 1 à 4, dans lequel ledit polysilicium déposé sur ladite plaquette fait l'objet de recuit à une température allant d'environ 850°C à environ 1000°C pour une durée d'environ 10 minutes à environ 60 minutes.

6. Procédé selon l'une quelconque des revendications 1 à 4, dans lequel ledit polysilicium déposé sur ladite plaquette fait l'objet d'un recuit rapide en élevant la température de la plaquette revêtue à une température de recuit allant d'environ 850°C à environ 1000°C suivant une vitesse allant d'environ 50°C/seconde à environ 100°C/seconde puis en maintenant la plaquette à ladite température de recuit pour une durée allant d'environ 10 secondes à environ 60 secondes.

7. Procédé selon l'une quelconque des revendications 2 à 6, dans lequel ladite source de silicium est admise à s'écouler dans ladite chambre à une vitesse équivalente à environ 100 à environ 1000 sccm dans une chambre de 3 litres, ladite source de silicium étant de préférence un silane gazeux, mieux encore SiH₄ et/ou Si₂H₆.

8. Procédé selon les revendications 2 à 7, dans lequel ledit dopant est du phosphore, de préférence PH_{3,} plus précisément sous forme d'un mélange d'environ 1% en volume de PH₃ et d'environ 99% en volume de H₂, de B₂H₃, de BCl₃ ou de AsH₃.
